# EUROPEAN PATENT SPECIFICATION

(11) **EP 0 387 552 B1**
(45) Date of publication and mention of the grant of the patent: **01.06.1994**
(21) Application number: 90103352.2
(22) Date of filing: 21.02.1990
(51) Int. Cl.: H01L 39/24

(54) **Method for manufacturing superconducting article**
Verfahren zur Herstellung eines supraleitenden Gegenstandes
Procédé pour la fabrication d'un dispositif à supraconducteur

(30) Priority: 13.03.1989 JP 60460/89
(43) Date of publication of application: 19.09.1990
(73) Proprietor: THE TOKAI UNIVERSITY JURIDICAL FOUNDATION, Shibuya-ku Tokyo (JP); NKK CORPORATION, Tokyo (JP)
(72) Inventor: Tachikawa, Kyoji, c/o Dept. of Materials Science, Hiratsuka-City, Kanagawa Pref. (JP); Shinbo, Yukio, c/o NKK CORPORATION, Tokyo (JP); Ono, Moriaki, c/o NKK CORPORATION, Tokyo (JP); Kosuge, Shigeyoshi, c/o NKK CORPORATION, Tokyo (JP); Kabasawa, Makoto, c/o NKK CORPORATION, Tokyo (JP)
(74) Representative: Henkel, Feiler, Hänzel & Partner

(56) References cited:
- EP-A- 0 301 656
- EP-A- 0 319 807
- JAPANESE JOURNAL OF APPLIED PHYSICS, vol. 27, no. 8, August 1988, pages L1501-L1503, Tokyo, Japan; K. TACHIKAWA et al.: "Fabrication of Superconducting Y-Ba-Cu Oxide Through an Improved Diffusion Process

## Description

### FIELD OF THE INVENTION

The present invention relates to a method for manufacturing a superconducting article comprising a substrate and a film of a superconducting substance formed on the surface of the substrate.

### BACKGROUND OF THE INVENTION

Superconducting materials have already been practically applied in the form of a superconducting magnet in a particle accelerator, a medical diagnosing instrument and the like. Potential applications of the superconducting materials include an electric power generator, an energy storage, a linear motor car, a magnetic separator, a nuclear fusion reactor, a power transmission cable, and a magnetic shielder. In addition, a superconducting element using the Josephson effect is expected to be applied in such fields as an ultra-high speed computer, an infrared sensor and a low-noise amplifier. The magnitude of industrial and social impact, which would exert upon practical realization of these possible application is really unmeasurable.

One of the typical superconducting materials so far developed is an Nb-Ti alloy which is widely used at present as a magnetizing wire. The Nb-Ti alloy has a critical temperature, i.e., a critical temperature from which a superconductive state occurs (hereinafter simply referred to as "Tc") of 9 K. As a superconducting material having a "Tc" considerably higher than that of the Nb-Ti alloy, a compound-type superconducting material has been developed, including an Nb₃Sn (Tc: 18 K) and V₃Ga (Tc: 15 K) which are now practically employed in the form of a wire.

As a superconducting material having a "Tc" further higher than those of the above-mentioned alloy-type and compound-type superconducting materials, a composite oxide superconducting material containing a CuₓO_{y}-radical has recently been developed. For example, a Y-Ba-Cu-O type superconducting material has a "Tc" of about 93 K. Since liquid nitrogen has a temperature of 77 K, liquid nitrogen available at a lower cost than liquid helium can be used as a cooling medium for the composite oxide superconducting material. Discovery of a superconducting material having a high "Tc" applicable at a temperature of liquid nitrogen urges further expectations for the foregoing fields of application. In the actual application, however, problems are how to process a superconducting material in the form of a film or a wire, and at the same time, how to increase a critical current density (hereinafter simply referred to as "Jc") of the superconducting material.

In order to increase "Jc" of a superconducting material, it is necessary, when using the superconducting material in the form of a film, to make the structure of the film dense with a single superconducting phase.

A method for manufacturing a superconducting article, in which "Jc" of a film of a superconducting material can be increased by making the structure of the film of the superconducting material dense with a single superconducting phase, is disclosed in the "Japanese Journal of Applied Physics", Vol. 27, No. 8, pages L1501-L1503, published on July 22, 1988 (hereinafter referred to as the "prior art"). The prior art is described below with reference to the drawings.

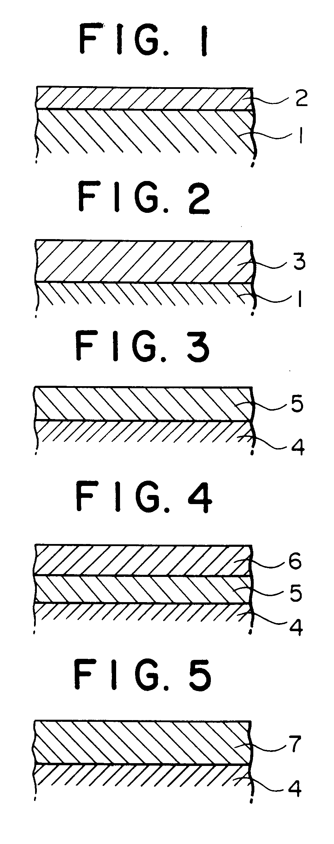

Fig. 1 is a schematic descriptive view illustrating the former half steps of the method of the prior art for manufacturing a superconducting article, and Fig. 2 is a schematic descriptive view illustrating the latter half steps of the method of the prior art for manufacturing the superconducting article. First, a sheet-shaped substrate 1 comprising Y₂BaCuOₓ is prepared. Then, a mixture of CuO and BaCO₃, in which the ratio of copper (Cu) to barium (Ba) is Cu : Ba = 5 : 3 in molar ratio, is primary-fired at a temperature of 800°C for 24 hours, cooled, and pulverized into a powder. The powder of the thus primary-fired mixture is then secondary-fired at a temperature of 900°C for 24 hours, cooled, and pulverized into a powder to prepare a powdery material for a film. Subsequently, the thus prepared powdery material for a film is mixed with ethyl alcohol to prepare a slurry for a film.

Then, the thus prepared slurry for film is applied onto the surface of the substrate 1, and dried to form a film 2 comprising Ba-Cu oxides on the surface of the substrate 1, as shown in Fig. 1. Then, the substrate 1, on the surface of which the film 2 has thus been formed, is heated in an electric furnace to melt the film 2 to cause the resultant melt of the Ba-Cu oxides in the film 2 to diffusion-react with Y₂BaCuOₓ in the substrate 1, thereby converting the film 2 into a film 3 of a superconducting substance comprising YBa₂Cu₃Oₓ, as shown in Fig. 2.

Then, the film 3 of the superconducting substance thus produced is cooled to a room temperature, thereby manufacturing a superconducting article comprising a non-reacting substrate 1 and the film 3 of the superconducting substance formed on the surface of the non-reacting substrate 1, as shown in Fig. 2.

The above-mentioned prior art has the following effects: Since the film 3 of the superconducting substance comprising YBa₂Cu₃Oₓ is produced through the diffusion-reaction of the resultant melt of the Ba-Cu oxides in the film 2 with Y₂BaCuOₓ in the substrate 1, the structure of the film 3 of the superconducting substance is dense with a single superconducting phase, thus permitting manufacture of a superconducting article having a high "Jc".

However, the above-mentioned prior art has the following problem: When the film 3 of the superconducting substance comprising YBa₂Cu₃Oₓ is produced on the surface of the substrate 1 through the diffusion-reaction of the resultant melt of the Ba-Cu oxides in the film 2 with Y₂BaCuOₓ in the substrate 1, the film 3 of the superconducting substance expands in volume, causing cracks in the film 3 of the superconducting substance and resulting in seriously deteriorated superconducting properties of the superconducting article including a largely decreased "Jc".

The above-mentioned problem occurs also in the case where the film 3 of a superconducting substance is produced by means of a compound containing a rare earth element other than "yttrium" (Y) in the above-mentioned Y₂BaCuOₓ and YBa₂Cu₃Oₓ. The rare earth element is hereinafter represented by "Ln".

### SUMMARY OF THE INVENTION

An object of the present invention is therefore to provide a method for manufacturing a superconducting article, which permits prevention, when producing a film of a superconducting substance comprising LnBa₂Cu₃Oₓ on the surface of a substrate through the diffusion-reaction, of the occurrence of cracks in the film of the superconducting substance, and as a result allows manufacture of the superconducting article having excellent superconducting properties.

In accordance with one of the features of the present invention, there is provided a method for manufacturing a superconducting article, characterized by comprising the steps of:
forming a first layer comprising a mixture of LnBa₂Cu₃Oₓ and Ln₂BaCuOₓ on the surface of a substrate, said Ln being a rare earth element, and the content ratio of Ln₂BaCuOₓ in said first layer being within the range of from 5 to 80 wt.% relative to the total amount of LnBa₂Cu₃Oₓ and Ln₂BaCuOₓ; then
forming a second layer comprising a mixture of at least CuO and BaCuO₂ on the surface of said first layer, said second layer having a melting point within the range of from 800 to 1,000°C; then
melting said mixure in said second layer, and keeping the molten state of said second layer for a period of time of from 1 minute to 4 hours in an oxygen-containing atmosphere to cause the resultant melt of said mixture in said second layer to diffusion-react with Ln₂BaCuOₓ in said first layer, thereby converting said first layer and said second layer into a film of a superconducting substance comprising LnBa₂Cu₃Oₓ; and
cooling said film of said superconducting substance thus produced to a room temperature, thereby manufacturing a superconducting article comprising said substrate and said film of said superconducting substance formed on the surface of said substrate.

### BRIEF DESCRIPTION OF THE DRAWINGS

Fig. 1 is a schematic descriptive view illustrating the former half steps in the method of the prior art for manufacturing a superconducting article;
Fig. 2 is a schematic descriptive view illustrating the latter half steps in the method of the prior art for manufacturing a superconducting article;
Fig. 3 is a schematic descriptive view illustrating the former half steps in an embodiment of the method of the present invention for manufacturing a superconducting article;
Fig. 4 is a schematic descriptive view illustrating the middle half steps in the embodiment of the method of the present invention for manufacturing a superconducting article; and
Fig. 5 is a schematic descriptive view illustrating the latter half steps in the embodiment of the method of the present invention for manufacturing a superconducting article.

### DETAILED DESCRIPTION OF PREFERRED EMBODIMENTS

From the above-mentioned point of view, extensive studies were carried out to develop a method for manufacturing a superconducting article, which permits prevention, when producing a film of a superconducting substance comprising LnBa₂Cu₃Oₓ on the surface of a substrate through the diffusion-reaction, of the occurrence of cracks in the film of the superconducting substance, and as a result allows manufacture of the superconducting article having excellent superconducting properties.

As a result, the following finding was obtained: Cracks occur in the film of the superconducting substance comprising LnBa₂Cu₃Oₓ because the film of the superconducting substance expands in volume when the film of the superconducting substance comprising LnBa₂Cu₃Oₓ is produced on the surface of the substrate through the diffusion reaction. Cracks can therefore be prevented from occurring in the film of the superconducting substance comprising LnBa₂Cu₃Oₓ, by reducing the amount of LnBa₂Cu₃Oₓ produced through the diffusion reaction to reduce the amount of expansion in volume of the film of the superconducting substance comprising LnBa₂Cu₃Oₓ.

The present invention was developed on the basis of the above-mentioned finding. Now, an embodiment of the method of the present invention for manufacturing a superconducting article is described below with reference to the drawings.

Fig. 3 is a schematic descriptive view illustrating the former half steps in an embodiment of the method of the present invention for manufacturing a superconducting article; Fig. 4 is a schematic descriptive view illustrating the middle half steps in the embodiment of the method of the present invention for manufacturing a superconducting article; and Fig. 5 is a schematic descriptive view illustrating the latter half steps in the embodiment of the method of the present invention for manufacturing a superconducting article.

In the method of the present invention for manufacturing a superconducting article, a first layer 5 comprising a mixture of LnBa₂Cu₃Oₓ and Ln₂BaCuOₓ is first formed by means of the known plasma metallizing method or the like on the surface of a substrate 4 as shown in Fig. 3. The substrate 4 comprises any one of ceramics, nickel and nickel-based alloy, which hardly react with a superconducting substance comprising LnBa₂Cu₃Oₓ. The content ratio of Ln₂BaCuOₓ in the first layer 5 should be within the range of from 5 to 80 wt.% relative to the total amount of LnBa₂Cu₃Oₓ and Ln₂BaCuOₓ.

The content ratio of Ln₂BaCuOₓ in the first layer 5 is limited within the above-mentioned range for the following reason: With a content ratio of Ln₂BaCuOₓ of under 5 wt.%, the amount of Ln₂BaCuOₓ in the first layer 5 is insufficient relative to the amount of a mixture in a second layer described later, so that a non-reacting fraction of the mixture in the second layer remains in a film described later of a superconducting substance comprising LnBa₂Cu₃Oₓ, which film is to be formed on the surface of the substrate 4, thus causing deterioration of superconducting properties of the film of the superconducting substance. With a content ratio of Ln₂BaCuOₓ of over 80 wt.%, on the other hand, the excessive amount of Ln₂BaCuOₓ makes it impossible to prevent cracks from occurring in the film of the superconducting substance comprising LnBa₂Cu₃Oₓ, which cracks are caused by the expansion in volume of the film during formation thereof.

Then, as shown in Fig. 4, a second layer 6 having a melting point within the range of from 800 to 1,000°C is formed by means of the known plasma metallizing method on the surface of the first layer 5. The second layer 6 comprises a mixture of at least CuO and BaCuO₂. A typical second layer 6 comprises a mixture of CuO, BaCuO₂ and BaO. In this case, the ratio of copper (Cu) to barium (Ba) in the second layer 6 should be within the range of Cu:Ba = 1:0.10 to 0.95 in molar ratio. Another example of the second layer 6 comprises a mixture of CuO, BaCuO₂, BaO, Y₂O₃ and YBa₂Cu₃O₇. In this case, the ratio of copper (Cu) to barium (Ba) and yttrium (Y) in the second layer 6 should be within the range of Cu:Ba:Y = 1:0.10 to 0.95 : 0.001 to 0.330 in molar ratio. Any of these mixtures in the second layer 6 diffusion-reacts with Ln₂BaCuOₓ in the first layer 5, and, as a result, the first layer 5 and the second layer 6 are converted into a film of a superconducting substance comprising LnBa₂Cu₃Oₓ, as described below.

Then, the mixture of the second layer 6 is melted, and the molten state of the second layer 6 is kept for a period of time of from 1 minute to 4 hours in an oxygen-containing atmosphere to cause the resultant melt of the mixture comprising at least CuO and BaCuO₂ in the second layer 6 to diffusion-react with Ln₂BaCuOₓ in the first layer 5, thereby converting the first layer 5 and the second layer 6 into a film 7 of a superconducting substance comprising LnBa₂Cu₃Oₓ, as shown in Fig. 5.

The period of time of keeping the molten state of the second layer 6 is limited within the range of from 1 minute to 4 hours for the following reason: With a period of time of molten state of the second layer 6 of under 1 minute, the resultant melt of the mixture in the second layer 6 cannot be caused to sufficiently diffusion-react with Ln₂BaCuOₓ in the first layer 5. With a period of time of molten state of the second layer 6 of over 4 hours, on the other hand, conversion of the first layer 5 and the second layer 6 into the film 7 of the superconducting substance comprising LnBa₂Cu₃Oₓ does not proceed further.

The thus produced film 7 of the superconducting substance is then cooled to a room temperature, thereby manufacturing a superconducting article comprising, as shown in Fig. 5, the substrate 4 and the film 7 of the superconducting substance formed on the surface of the substrate 4.

According to the method of the present invention for manufacturing a superconducting article, as described above, the first layer 5 previously contains LnBa₂Cu₃Oₓ in a prescribed amount, and this reduces the amount of LnBa₂Cu₃Oₓ produced through the diffusion-reaction of the melt of the mixture in the second layer 6 with Ln₂BaCuOₓ in the first layer 5. As a result, the amount of expansion in volume of the film 7 of the superconducting substance comprising LnBa₂Cu₃Oₓ is reduced, thus preventing cracks from occurring in the film 7 of the superconducting substance.

Now, the method of the present invention for manufacturing a superconducting article is described in more detail by means of examples with reference to Figs. 3 to 5.

### EXAMPLE 1

A mixture of CuO, BaCO₃ and Y₂O₃, in which the ratio of copper (Cu) to barium (Ba) and yttrium (Y) was Cu : Ba : Y = 2 : 1.5 : 1.5 in molar ratio, was primary-fired at a temperature of 900°C for 10 hours, cooled and pulverized into a powder. The powder of the thus primary-fired mixture was then secondary-fired at a temperature of 920°C for 10 hours, cooled and pulverized into a powder. The powder of the thus secondary-fired mixture was then tertiary-fired at a temperature of 950°C for 10 hours, cooled and pulverized into a powder to prepare a powdery material for first layer, having an average particle size within the range of from 26 to 44 µm. The thus prepared powdery material for first layer comprised a mixture of YBa₂Cu₃Oₓ and Y₂BaCuOₓ, and the content ratio of Y₂BaCuOₓ in the powdery material for first layer was 50 wt.% relative to the total amount of YBa₂Cu₃Oₓ and Y₂BaCuOₓ.

On the other hand, a mixture of CuO and BaCO₃, in which the ratio of copper (Cu) to barium (Ba) was Cu : Ba = 2 : 1 in molar ratio, was primary-fired at a temperature of 900°C for 10 hours, cooled and pulverized into a powder. The powder of the thus primary-fired mixture was then secondary-fired at a temperature of 920°C for 10 hours, cooled and pulverized into a powder. The powder of the thus secondary-fired mixture was then tertiary-fired at a temperature of 950°C for 30 minutes, cooled and pulverized into a powder to prepare a powdery material for second layer, having an average particle size within the range of from 26 to 44 µm. The thus prepared powdery material for second layer comprised a mixture of CuO, BaCuO₂ and BaO.

Then, the powdery material for first layer prepared as described above was blown by means of the known plasma metallizing method onto the surface of a substrate 4 having a surface area of 1 cm² and a thickness of 1 mm and comprising a nickel-based alloy, to form a first layer 5 having a thickness of 50 µm on the surface of the substrate 4, as shown in Fig. 3.

Then, the powdery material for second layer prepared as described above was blown by means of the known plasma metallizing method onto the surface of the first layer 5, to form a second layer 6 having a thickness of 50 µm on the surface of the first layer 5, as shown in Fig. 4.

Then, the substrate 4, on the surface of which the first layer 5 and the second layer 6 were thus formed, was heated to a temperature of 950°C in an electric furnace having an interior atmosphere of air to melt the second layer 6, and the molten state of the second layer 6 was kept for 30 minutes. This permitted the diffusion reaction of the resultant melt of the mixture of CuO, BaCuO₂ and BaO in the second layer 6 with Y₂BaCuOₓ in the first layer 5, whereby the first layer 5 and the second layer 6 were converted into a film 7 of a superconducting substance comprising YBa₂Cu₃Oₓ having a thickness of 70 µm, as shown in Fig. 5.

The substrate 4, on the surface of which the film 7 of the superconducting substance was thus produced, was slowly cooled in the electric furnace to a room temperature.

Thus, a superconducting article was manufactured, which comprised the substrate 4 comprising a nickel-based alloy and the film 7 of the superconducting substance comprising YBa₂Cu₃Oₓ formed on the surface of the substrate 4, as shown in Fig. 5.

Investigation of the thus manufactured superconducting article revealed that the structure of the film 7 was dense with a single superconducting phase, and the superconducting article had a "Jc" of 1,000 A/cm².

### EXAMPLE 2

A mixture of CuO, BaCO₃ and Y₂O₃, in which the ratio of copper (Cu) to barium (Ba) and yttrium (Y) was Cu : Ba : Y = 2.4 : 1.7 : 1.3 in molar ratio, was primary-fired at a temperature of 900°C for 10 hours, cooled and pulverized into a powder. The powder of the thus primary-fired mixture was then secondary-fired at a temperature of 920°C for 10 hours, cooled and pulverized into a powder. The powder of the thus secondary-fired mixture was then tertiary-fired at a temperature of 950°C for 10 hours, cooled and pulverized into a powder to prepare a powdery material for first layer, having an average particle size within the range of from 26 to 44 µm. The thus prepared powdery material for first layer comprised a mixture of YBa₂Cu₃Oₓ and Y₂BaCuOₓ, and the content ratio of Y₂BaCuOₓ in the powdery material for first layer was 30 wt.% relative to the total amount of YBa₂Cu₃Oₓ and Y₂BaCuOₓ.

On the other hand, a mixture of CuO, BaCO₃ and Y₂O₃, in which the ratio of copper (Cu) to barium (Ba) and yttrium (Y) was Cu : Ba : Y = 26 : 13 : 1 in molar ratio, was primary-fired at a temperature of 900°C for 10 hours, cooled and pulverized into a powder. The powder of the thus primary-fired mixture was then secondary-fired at a temperature of 920°C for 10 hours, cooled and pulverized into a powder. The powder of the thus secondary-fired mixture was then tertiary-fired at a temperature of 950°C for 30 minutes, cooled and pulverized into a powder to prepare a powdery material for second layer, having an average particle size within the range of from 26 to 44 µm. The thus prepared powdery material for second layer comprised a mixture of CuO, BaCuO₂, BaO, Y₂O₃ and YBa₂Cu₃O₇.

Then, the powdery material for first layer prepared as described above was blown by means of the known plasma metallizing method onto the surface of a substrate 4 having a surface area of 1 cm² and a thickness of 1 mm and comprising a nickel-based alloy, to form a first layer 5 having a thickness of 50 µm on the surface of the substrate 4, as shown in Fig. 3.

Then, the powdery material for second layer prepared as described above was blown by means of the known plasma metallizing method onto the surface of the first layer 5, to form a second layer 6 having a thickness of 50 µm on the surface of the first layer 5, as shown in Fig. 4.

Then, the substrate 4, on the surface of which the first layer 5 and the second layer 6 were thus formed, was heated to a temperature of 950°C in an electric furnace having an interior atmosphere of air to melt the second layer 6, and the molten state of the second layer 6 was kept for 30 minutes. This permitted the diffusion reaction of the resultant melt of the mixture of CuO, BaCuO₂, BaO, Y₂O₃ and YBa₂Cu₃O₇ in the second layer 6 with Y₂BaCuOₓ in the first layer 5, whereby the first layer 5 and the second layer 6 were converted into a film 7 of a superconducting substance comprising YBa₂Cu₃Oₓ having a thickness of 70 µm, as shown in Fig. 5.

Then, the substrate 4, on the surface of which the film 7 of the superconducting substance was thus produced, was slowly cooled in the electric furnace to a room temperature.

Thus, a superconducting article was manufactured, which comprised the substrate 4 comprising a nickel-based alloy and the film 7 of the superconducting substance comprising YBa₂Cu₃Oₓ formed on the surface of the substrate 4, as shown in Fig. 5.

Investigation of the thus manufactured superconducting article revealed that the structure of the film 7 was dense with a single superconducting phase, and the superconducting article had a "Jc" of 1,100 A/cm².

According to the method of the present invention, as described above in detail, it is possible to manufacture a superconducting article having excellent superconducting properties, in which cracks are prevented from occurring in a film of a superconducting substance comprising LnBa₂Cu₃Oₓ, when the film of the superconducting substance is produced on the surface of a substrate through the diffusion-reaction, thus providing industrially useful effects.

## Claims

1. A method for manufacturing a superconducting article, characterized by comprising the steps of:
forming a first layer comprising a mixture of LnBa₂Cu₃Oₓ and Ln₂BaCuOₓ on the surface of a substrate, said Ln being a rare earth element, and the content ratio of Ln₂BaCuOₓ in said first layer being within the range of from 5 to 80 wt.% relative to the total amount of LnBa₂Cu₃Oₓ and Ln₂BaCuOₓ; then
forming a second layer comprising a mixture of at least CuO and BaCuO₂ on the surface of said first layer, said second layer having a melting point within the range of from 800 to 1,000°C; then
melting said mixture in said second layer, and keeping the molten state of said second layer for a period of time of from 1 minute to 4 hours in an oxygen-containing atmosphere to cause the resultant melt of said mixture in said second layer to diffusion-react with Ln₂BaCuOₓ in said first layer, thereby converting said first layer and said second layer into a film of a superconducting substance comprising LnBa₂Cu₃Oₓ; and
cooling said film of said superconducting substance thus produced to a room temperature, thereby manufacturing a superconducting article comprising said substrate and said film of said superconducting substance formed on the surface of said substrate.

2. The method as claimed in Claim 1, wherein:
said substrate comprises any one of ceramics, nickel and nickel-based alloy.

3. The method as claimed in Claim 1 or 2, wherein:
said second layer comprises a mixture of CuO, BaCuO₂ and BaO; and
the ratio of copper (Cu) to barium (Ba) in said second layer is within the range of Cu : Ba = 1 : 0.10 to 0.95 in molar ratio.

4. The method as claimed in Claim 1 or 2, wherein:
said rare element Ln is Yttrium;
said second layer comprises a mixture of CuO, BaCuO₂, BaO, Y₂O₃ and YBa₂Cu₃O₇; and
the ratio of copper (Cu) to barium (Ba) and yttrium (Y) in said second layer is within the range of Cu : Ba : Y = 1 : 0.10 to 0.95 : 0.001 to 0.330 in molar ratio.

## Patentansprüche

1. Verfahren zur Herstellung eines supraleitenden Gegenstandes, gekennzeichnet durch folgende Stufen:
Ausbilden einer ein Gemisch aus LnBa₂Cu₃Oₓ und Ln₂BaCuOₓ mit Ln gleich einem Seltenerdeelement umfassenden ersten Schicht auf der Oberfläche eines Substrats, wobei der Mengenanteil Ln₂BaCuOₓ in der ersten Schicht im Bereich von 5 bis 80 Gew.-%, bezogen auf die Gesamtmenge an LnBa₂Cu₃Oₓ und Ln₂BaCuOₓ, beträgt; anschließend
Ausbilden einer ein Gemisch aus zumindest CuO und BaCuO₂ umfassenden zweiten Schicht auf der Oberfläche der ersten Schicht, wobei die zweite Schicht einen Schmelzpunkt im Bereich von 800 bis 1000°C aufweist; anschließend
Aufschmelzen des Gemischs in der zweiten Schicht und Aufrechterhalten des Schmelzezustands der zweiten Schicht während 1 min bis 4 h in einer sauerstoffhaltigen Atmosphäre, um die gebildete Schmelze des Gemischs in der zweiten Schicht zu einer Diffusionsreaktion mit Ln₂BaCuOₓ in der ersten Schicht zu veranlassen und dabei die erste Schicht und die zweite Schicht in einen Film aus einer LnBa₂Cu₃Oₓ umfassenden supraleitenden Substanz umzuwandeln; und
Abkühlen des gebildeten Films aus der supraleitenden Substanz auf Raumtemperatur zur Herstellung eines supraleitenden Gegenstandes, umfassend das Substrat und den auf der Substratoberfläche gebildeten Film aus der supraleitenden Substanz.

2. Verfahren nach Anspruch 1, wobei das Substrat aus irgendeiner Keramik, Nickel oder einer Legierung auf Nickelbasis besteht.

3. Verfahren nach Anspruch 1 oder 2, wobei die zweite Schicht ein Gemisch aus CuO, BaCuO₂ und BaO umfaßt und das Molverhältnis Kupfer (Cu) zu Barium (Ba) in der zweiten Schicht Cu/Ba im Bereich von 1/0,10 bis 0,95 liegt.

4. Verfahren nach Anspruch 1 oder 2, wobei das durch Ln dargestellte Seltenerdeelement aus Y besteht, die zweite Schicht ein Gemisch aus CuO, BaCuO₂, BaO, Y₂O₃ und YBa₂Cu₃O₇ umfaßt und das Molverhältnis Kupfer (Cu) zu Barium (Ba) und Yttrium (Y) in der zweiten Schicht Cu/Ba/Y 1/0,10 bis 0.95/0,001 bis 0,330 beträgt.

## Revendications

1. Un procédé pour fabriquer un article supraconducteur, caractérisé en ce qu'il comporte les phases consistant à :
former une première couche comportant un mélange de LnBa₂Cu₃Oₓ et Ln₂BaCuOₓ sur la surface d'un substrat, ledit Ln étant un élément de terre rare, et la teneur en Ln₂BaCuOₓ dans ladite première couche se situant dans la plage de 5 à 80 % en poids par rapport à la quantité totale de LnBa₂Cu₃Oₓ et Ln₂BaCuOₓ ; puis
former une seconde couche comportant un mélange d'au moins CuO et BaCuO₂ sur la surface de ladite première couche, ladite seconde couche présentant un point de fusion dans la plage de 800 à 1.000°C; puis
faire fondre ledit mélange de la seconde couche et maintenir l'état fondu de ladite seconde couche pendant une durée de 1 minute à 4 heures dans une atmosphère contenant de l'oxygène pour amener la matière fondue résultante dudit mélange de la seconde couche à réagir par diffusion avec Ln₂BaCuOₓ de ladite première couche, pour convertir ainsi ladite première couche et ladite seconde couche en une pellicule d'une substance supraconductrice comportant LnBa₂Cu₃Oₓ; et
refroidir ladite pellicule de ladite substance supraconductrice ainsi formée à la température ambiante, pour fabriquer ainsi un article supraconducteur comportant ledit substrat et ladite pellicule de ladite substance supraconductrice formée sur la surface dudit substrat.

2. Le procédé tel que revendiqué dans la revendication 1, dans lequel :
ledit substrat comporte l'un quelconque d'une céramique, du nickel ou d'un alliage à base de nickel.

3. Le procédé tel que revendiqué dans la revendication 1 ou 2, dans lequel :
ladite seconde couche comporte un mélange de CuO, de BaCuO₂ et de BaO ; et
le rapport du cuivre (Cu) au baryum (Ba) dans ladite seconde couche est situé dans la plage de Cu : Ba = 1 : 0,10 à 0,95 en rapport molaire.

4. Le procédé tel que revendiqué dans la revendication 1 ou 2, dans lequel :
l'élément de terre rare Ln est Y ;
ladite seconde couche comporte un mélange de CuO, de BaCuO₂, de BaO, de Y₂O₃ et de YBa₂Cu₃O₇ ; et
le rapport du cuivre (Cu) au baryum (Ba) et à l'yttrium (Y) dans ladite seconde couche est dans la plage de Cu : Ba : Y = 1 : 0,10 à 0,95 : 0,001 à 0,330 en rapport molaire.
